# EUROPÄISCHE PATENTANMELDUNG

(11) **EP 3 576 510 A1**
(43) Veröffentlichungstag der Anmeldung: **04.12.2019**
(21) Anmeldenummer: 18174790.8
(22) Anmeldetag: 29.05.2018
(51) Int. Cl.: H05K 7/20, B60L 3/00, G01P 5/10

(54) **KÜHLEINRICHTUNG FÜR EINE ELEKTRISCHE SCHALTANLAGE UND VERFAHREN ZUM BETREIBEN EINER SOLCHEN KÜHLEINRICHTUNG**

(71) Anmelder: Siemens Aktiengesellschaft, 80333 München (DE)
(72) Erfinder: Schrott, Hans-Georg, 91346 Wiesenttal OT Streitberg (DE); Schönewolf, Stefan Hans Werner, 90489 Nürnberg (DE)

(57) **Zusammenfassung**

Die Erfindung betrifft eine Kühleinrichtung für eine elektrische Anlage, insbesondere für ein Umrichtersystem einer elektrischen Anlage eines Schienenfahrzeugs, mit einem Kühlpfad (39), in welcher wenigstens eine Verlustleistungsquelle (14) angeordnet ist und welcher von einem Kühlmittel durchströmbar ist, und mit einer Temperatursensorik zum Erfassen eines Ausfalls eines Massenstromes des Kühlmittels, welche wenigstens zwei in Transportrichtung des Kühlmittels voneinander beabstandet in den Kühlpfad (39) integrierte Temperatursensoren (52,54) umfasst, wobei die beiden Temperatursensoren (52,54) in Transportrichtung des Kühlmittels vor einer Passage (24) des Massenstroms des Kühlmittels durch einen Überdeckungsbereich des Kühlpfads (39) mit der Verlustleistungsquelle (14) angeordnet sind. Darüber hinaus betrifft die Erfindung ein Verfahren zum Betreiben einer derartigen Kühleinrichtung.

## Beschreibung

Die Erfindung betrifft eine Kühleinrichtung für eine elektrische Anlage, insbesondere für ein Umrichtersystem einer elektrischen Anlage eines Schienenfahrzeugs, gemäß dem Oberbegriff des Patentanspruchs 1. Des Weiteren betrifft die Erfindung ein Verfahren zum Betreiben einer derartigen Kühleinrichtung gemäß dem Oberbegriff des Patentanspruchs 6.

Beim Betrieb von elektrischen Anlagen, beispielsweise von Umrichtersystemen einer elektrischen Anlage eines Schienenfahrzeugs im Eisenbahnbereich, fallen an Verlustleistungsquellen wie beispielsweise Leistungshalbleitern entsprechend hohe Verluste in Form von thermischer Energie, also von Wärme, an. Um hierbei ein Überhitzen der Anlage, insbesondere der elektrischen Komponenten wie Si-IGBT (Insulated-Gate-Bipolar-Transistor = Bipolartransistor mit isolierter Gate-Elektrode) oder SiC-MOSFET (Metaloxide-Semiconductor-Field-Effect-Transistor = Metall-Oxid-Halbleiter-Feldeffekttransistor) zu vermeiden, ist eine geeignete Wärmeabfuhr erforderlich. Dies erfolgt üblicherweise über in Kühlkreisläufen zirkulierende Kühlmedien in flüssigem oder gasförmigen Zustand, welche die thermische Energie aufnehmen und abtransportieren.

Ein großes Problem stellt hierbei ein Ausfall der Kühleinrichtung beziehungsweise des Kühlkreislaufes dar, sodass der Massestrom des Kühlmittels abrupt stoppt und somit keine Wärme mehr von den Verlustleistungsquellen abgeführt wird. Infolgedessen kann es zu Schäden an den zu kühlenden Komponenten kommen.

Aus diesem Grund ist eine zuverlässige Überwachung des Massenstroms des Kühlmittels unumgänglich, um bei einer Störung entsprechende Maßnahmen zur Vermeidung von Folgeschäden - wie beispielsweise das Abschalten des Umrichtersystems - ergreifen zu können. Hierbei ist zu berücksichtigen, dass durch die Steigerung der Leistungsdichte in derartigen Verlustleistungsquellen wie Umrichtern eine kontinuierliche und zuverlässige Abfuhr der thermischen Energie an weiterer Bedeutung gewinnt.

Bei einer leistungsstarken und zuverlässigen Abfuhr der anfallen thermischen Energie beziehungsweise Wärme ist es überdies erforderlich, dass fehlerhafte oder unbeabsichtigte Ausfälle in Form von vermeintlichen, jedoch tatsächlich nicht vorhandenen Unterbrechungen des Massestroms des Kühlmittels unbedingt vermieden werden sollen, um eine hohe Verfügbarkeit und Zuverlässigkeit der elektrischen Anlage, beispielsweise des darin enthaltenen Umrichtersystems, zu erhalten. Hierbei ist zu berücksichtigen, dass gerade sprunghafte Temperaturänderungen des in dem Kühlkreislauf zirkulierenden Kühlmittels zu derartigen fehlerhaften und unbeabsichtigten Auslösungen führen können, sofern als Detektionsprinzip für eine Erkennung der Unterbrechung des Massenstroms des Kühlmittels eine oder mehrere Temperaturmessungen herangezogen werden. Im Bahnbereich entstehen derartige sprunghafte Temperaturänderungen beispielsweise bei plötzlichen Änderungen der Umgebungsbedingungen, zum Beispiel bei der Einfahrt eines Schienenfahrzeugs in einen Tunnel, sodass der in einem Wärmetauscher den Massenstrom des Kühlmittels kühlende weitere Stoffstrom - beispielsweise den Wärmetauscher durchströmende Kühlluft - abrupt eine andere Temperatur aufweist, die demzufolge zum beschriebenen Temperatursprung des anderen Stoffstroms des Wärmetauschers, nämlich des Massenstroms des Kühlmittels, führt.

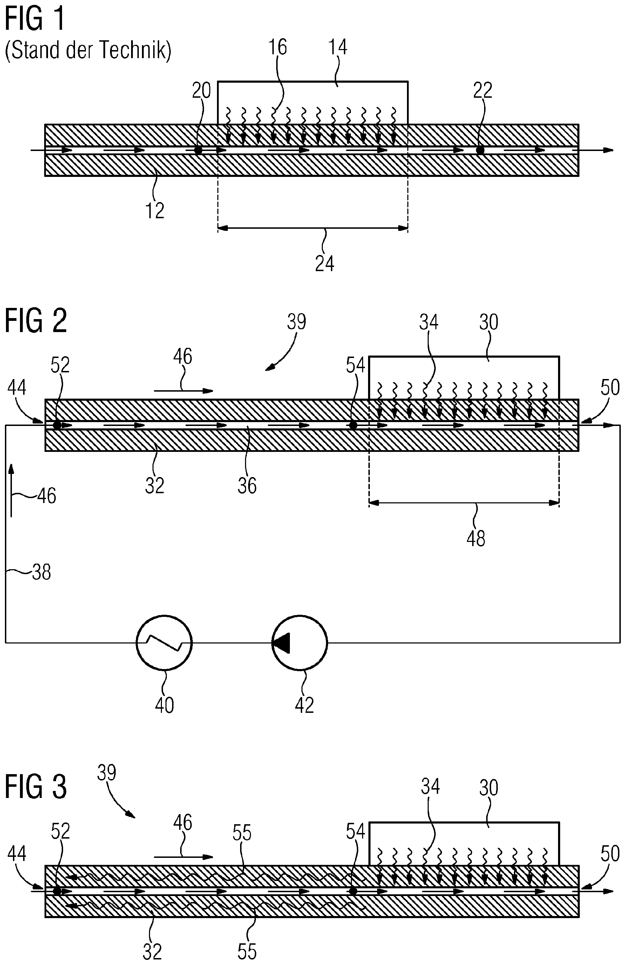

Gemäß dem in FIG 1 dargestellten Stand der Technik werden bislang mehrere Möglichkeiten in Betracht gezogen, um den Ausfall des Massenstroms des Kühlmittels zu erkennen. In FIG 1 ist hierbei in einer schematischen Ansicht eine Kühleinrichtung für eine elektrische Anlage, insbesondere für ein Umrichtersystem eines Schienenfahrzeugs erkennbar, bei welchem von einem Kühlkreislauf ein entsprechender Kühlmittelkanal ausschnittsweise erkennbar ist. Innerhalb des Kühlkreislaufs ist dabei ein hier nicht erkennbarer Wärmetauscher zur Abkühlung des Kühlmittels angeordnet, welcher beispielsweise bei einem Schienenfahrzeug von der Umgebungsluft als dem einen Stoffstrom umströmt werden kann, mittels welchem der Massestrom des Kühlmittels als zweiter Stoffstrom in Wärmeaustausch steht. Ein Kühlkanal durchsetzt im vorliegenden Fall einen Kühlkörper 12, welcher seinerseits mit einer Verlustleistungsquelle 14 verbunden beziehungsweise thermisch gekoppelt ist. Bei der Verlustleistungsquelle 14 handelt es sich beispielsweise um ein IGBT-Modul (Insulated-Gate-BipolarTransistor = Bipolartransistor mit isolierter Gate-Elektrode)des Umrichtersystems. Mit Pfeilen 16 ist dabei der Eintrag einer thermischen Energie von Wärme aus der Verlustleistungsquelle 14 in den Kühlkörper 12 symbolisiert.

Der Ausfall des Massenstroms des den Kühlkanal durchströmenden Kühlmittels kann nun gemäß dem Stand der Technik bislang auf zwei verschiedene Arten ermittelt werden: zum einen sind Systeme mit einem jeweiligen Sensor 18 bekannt, mittels welchem der Massenstrom beziehungsweise die Durchflussmenge an Kühlmittel ermittelt werden kann. Derartige Durchflusssensoren 18 sind allerdings häufig teuer und auch relativ unzuverlässig. Zum anderen ist es bekannt, die jeweiligen Temperatursensoren 20, 22 vor beziehungsweise hinter einer Passage 24 des Massenstroms des Kühlmittels durch einen Überdeckungsbereich des Kühlkreislaufs beziehungsweise des Kühlkanals 10 mit der Verlustleistungsquelle 14 angeordnet sind. Unter der Passage 24 ist demzufolge derjenige Längenbereich des Kühlkanals 10 zu verstehen, welcher in Überdeckung mit der Verlustleistungsquelle 14 liegt.

Anhand der Temperatursensoren 20, 22 wird somit eine jeweilige Temperatur des Kühlmittels vor Eintritt in die Passage 24 beziehungsweise nach Austritt aus dieser gemessen.

Ist der Verlustleistungseintrag, also der Eintrag an thermischer Energie beziehungsweise Wärme der zu kühlenden Verlustleistungsquelle 14 in das Kühlmittel bekannt, so kann aus der über die beiden Temperatursensoren 20, 22 ermittelten Temperaturdifferenz vor und hinter der Verlustleistungsquelle 14 der Massestrom des Kühlmittels bestimmt werden, sofern die Wärmekapazität des Kühlmittels bekannt ist. Fällt der berechnete Wert des Stroms unter einen gewissen Grenzwert, ist von einer Störung auszugehen.

Allerdings benötigt dieses System eine genaue Kenntnis über die momentan in das Kühlsystem eingetragene Verlustleistung der Verlustleistungsquelle 14. Dies erfordert eine genaue Modellbildung beispielsweise des Schaltverhaltens und des Durchlassverhaltens der zur Kühlung vorgesehenen Verlustleistungsquelle 14, wenn die Verlustleistungsquelle 14 als Leistungshalbleiter (IGBT, MOSFET) ausgebildet ist, um die daraus resultierenden Verluste kontinuierlich mittels einer Recheneinrichtung bestimmen zu können. Dies bringt einen erheblichen Aufwand und Unsicherheiten innerhalb der Modellierungen mit sich. Außerdem ist die Ermittlung der jeweiligen Temperaturen des Kühlmittels vor und hinter der Verlustleistungsquelle 14 empfindlich für Temperatursprünge des in den Kühlkörper 12 beziehungsweise die Passage 24 eintretenden Kühlmittels, beispielsweise wenn sich die Temperatur des Kühlmittels bei einer Einfahrt des Schienenfahrzeugs in einen Tunnel in Folge der dann geänderten Wärmetauscherumgebung sich abrupt verändert. Da nämlich in die Durchflussberechnung die Temperaturdifferenz der beiden Sensoren 20, 22 eingeht, führt ein Sprung der Kühlmitteltemperatur vor dem Eintritt in die Passage 24, welche durch den vor der Verlustleistungsquelle 14 angeordneten Temperatursensor 20 bereits erfasst wird, aber aufgrund der Bewegungsgeschwindigkeit des Kühlmittels noch nicht am Ende der Passage 24 beim zweiten Temperatursensor 22 erfasst werden kann, zu einem Fehler im berechneten Durchfluss. Somit kann es zu einer fehlerhaften und unbeabsichtigten Auslösung einer Ausfallerkennung des Massenstroms des Kühlmittels kommen.

Aufgabe der vorliegenden Erfindung ist es daher, eine Kühleinrichtung für eine elektrische Anlage, insbesondere für ein Umrichtersystem einer elektrischen Anlage eines Schienenfahrzeugs, sowie ein Verfahren zum Betreiben einer derartigen Kühleinrichtung zu schaffen, mittels welchen sich einerseits eine einfache und kostengünstige Lösung zur Ausfallerkennung realisieren lässt, und welche andererseits äußerst unanfällig für eine fehlerhafte beziehungsweise unbeabsichtigte Auslösung bei tatsächlich nicht vorhandenem Ausfall des Massestroms des Kühlmittels ist.

Diese Aufgabe wird erfindungsgemäß durch eine Kühleinrichtung mit den Merkmalen des Patentanspruchs 1 sowie durch ein Verfahren zum Betreiben einer derartigen Kühleinrichtung mit den Merkmalen des Patentanspruchs 5 gelöst. Vorteilhafte Ausgestaltungen mit günstigen Weiterbildungen der Erfindung sind Gegenstand der jeweiligen abhängigen Ansprüche.

Die erfindungsgemäße Kühleinrichtung für eine elektrische Schaltanlage, insbesondere für ein Umrichtersystem einer elektrischen Anlage eines Schienenfahrzeugs, umfasst einen Kühlpfad, in welchem wenigstens eine Verlustleistungsquelle integriert beziehungsweise in diesem angeordnet ist und welcher von einem flüssigen oder gasförmigen Kühlmittel durchstömbar ist. Überdies umfasst die Kühleinrichtung eine Temperatursensorik zum Erfassen eines Ausfalls eines Massenstromes des Kühlmittels und somit zum Detektieren eines Ausfalls der gesamten Kühleinrichtung, wobei die Temperatursensorik zwei in Transportrichtung des Kühlmittels voneinander beabstandet in den Kühlpfad integrierte Temperatursensoren umfasst, welche erfindungsgemäß in Transportrichtung des Kühlmittels vor einer Passage des Massenstroms des Kühlmittels durch einen Überdeckungsbereich des Kühlpfads mit der Verlustleistungsquelle angeordnet sind. Der Überdeckungsbereich von Verlustleistungsquelle und Kühlpfad ist als derjenige Bereich definiert, in dem der hauptsächliche Wärmestrom von Wärmequelle zum Kühlmittel im Normalbetrieb geführt wird.

Im Unterschied zum bisherigen Stand der Technik, bei welchem die jeweiligen Temperaturen des Kühlmittels in dessen Transportrichtung vor dessen Eintritt in die Passage des Massenstroms durch den Überdeckungsbereich des Kühlpfads mit der Verlustleistungsquelle beziehungsweise nach dessen Austritt ermittelt worden sind, ist nunmehr erfindungsgemäß vorgesehen, die jeweiligen Temperaturen in größerem und kleineren Abstand vor Eintritt in die Passage des Massenstroms des Kühlmittels durch den Überdeckungsbereich des Kühlpfads mit der Verlustleistungsquelle zu messen.

Der wesentliche Vorteil einer derartigen Messung ist es, dass somit in einfacher Weise lediglich eine Temperaturdifferenz zwischen den beiden Temperaturmessstellen in größerem und kleineren Abstand vor Eintritt in die Passage des Massenstroms des Kühlmittels durch den Überdeckungsbereich des Kühlpfads mit der Verlustleistungsquelle ausgewertet werden muss, wobei ein Ausfall des Massenstroms immer dann vorliegt, wenn die Temperaturdifferenz deutlich höher als im Normalbetrieb ist und bei transienten Vorgängen der Temperaturanstieg des Kühlmittels im Nahbereich der Verlustleistungsquelle dem Temperaturanstieg an der demgegenüber weiter von der Verlustleistungsquelle entfernten Erfassungsstelle der Temperatur des Kühlmittels vorauseilt. Beide Teile dieser Bedingungen können dabei in einfacher Weise mit einer geeigneten, überlagerten Steuerung überprüft werden. Hierbei sind im Unterschied zum bisherigen Stand der Technik keine aufwändige Modellierungen des thermischen Verhaltens des Kühlmittels beziehungsweise des Gesamtsystems und keine Kenntnis der aktuell eingebrachten Verlustleistung in der Verlustleistungsquelle in das Kühlmittel notwendig, um diese Erkennung umzusetzen.

Ein weiterer großer Vorteil ist es, dass Temperatursprünge, welche beispielsweise bei vorhandener Zirkulation und Umwälzung des Kühlmittels in Folge einer Temperaturveränderung beispielsweise im Bereich des Wärmetauschers entstehen, wie sich dies im Eisenbahnbetrieb beispielsweise bei sich verändernden Temperaturen auf der Zugstrecke (Einfahrt in einen Tunnel) ergeben kann, weitaus robuster abgefangen werden können. Eine derartige Temperaturänderung der Außenumgebung führt nämlich beispielsweise in Folge des dann wärmeren Stoffstroms der Kühlluft am Wärmetauscher zu einem solchen Temperatursprung des anderen Stoffstroms, nämlich des Massenstroms des Kühlmittels, welcher dann mittels der beiden Temperatursensoren erfasst wird.

Da hierbei zunächst der von der Passage des Stroms durch den Überdeckungsbereich des Kühlpfads mit der Verlustleistungsquelle entferntere Temperatursensor einen Temperaturanstieg erfasst, bevor dieser Temperaturanstieg auch durch einen näher an der Passage angeordneten zweiten Sensor erfasst wird kann diese Betriebssituation von einem Ausfall des Massenstroms des Kühlmittels unterschieden werden, bei dem der korrespondierende zeitliche Temperaturgradient stets zuerst von dem, dem Überdeckungsbereich zugewandten, Temperatursensor erfasst wird., Infolgedessen ergibt sich insgesamt ein äußerst kostengünstiges und störungsunanfälliges Gesamtsystem zur Überwachung des Massenstroms des Kühlmittels innerhalb des Kühlpfads. Der Kühlpfad ist dabei insbesondere Teil eines Kühlkreislaufes, in welchen ein Wärmetauscher integriert ist. Gleichwohl wäre auch ein offenes System denkbar, bei welchem beispielsweise mittels eines Lüfters Umgebungsluft durch den Kühlpfad geblasen wird. Dann ist der Kühlkreislauf nicht mehr richtig geschlossen (nur über Umgebungsluft). Ein Wärmetauscher ist dann auch nicht erforderlich.

In weiterer Ausgestaltung der Erfindung hat es sich dabei als vorteilhaft gezeigt, wenn die Verlustleistungsquelle mit einem in den Kühlpfad integrierten Kühlkörper Wärme leitend gekoppelt, beispielsweise unmittelbar verbunden oder einstückig mit diesem ausgestaltet, ist, wobei die beiden Temperatursensoren dann an dem Kühlkörper angeordnet sind. Der Kühlkörper sorgt somit einerseits für eine homogene Temperaturabfuhr der thermischen Energie aus der Verlustleistungsquelle und ermöglicht eine sehr feine und genaue Temperaturerfassung mittels der beiden Temperatursensoren.

In diesem Zusammenhang hat es sich in weiterer Ausgestaltung der Erfindung als besonders vorteilhaft gezeigt, wenn der eine Temperatursensor in Transportrichtung des Kühlmittels im Bereich eines Eintritts des Massenstromes in den Kühlkörper und der weitere Temperatursensor im Nahbereich vor der Passage des Massenstroms durch den Überdeckungsbereich des Kühlpfads mit der Verlustleistungsquelle angeordnet ist. Auf diese Art und Weise ist insbesondere eine Wärmeausbreitung in Folge des Eintrags einer thermischen Energie durch die Verlustleistungsquelle beim Ausfall des Massenstroms besonders schnell und zuverlässig ermittelbar, wenn der im Nahbereich vor der Passage des Massenstroms durch den Überdeckungsbereich des Kühlpfads mit der Verlustleistungsquelle angeordnete Temperatursensor einen entsprechenden, ungewöhnlichen Temperaturanstieg ermittelt.

Eine weitere vorteilhafte Ausführungsform der Erfindung sieht überdies eine Mehrzahl von Verlustleistungsquellen vor, wobei die beiden Temperatursensoren voneinander beabstandet in Transportrichtung des Kühlmittels vor einer Passage des Massenstroms durch einen Überdeckungsbereich des Kühlpfads mit einer der Verlustleistungsquellen angeordnet sind. Im Ergebnis kann somit in einfacher Weise eine Überhitzung mehrerer, innerhalb des Kühlpfads hintereinander angeordneter Verlustleistungsquellen durch eine einzige Anordnung von zwei Temperatursensoren vor einer der Verlustleistungsquellen - in Transportrichtung des Kühlmittels gesehen - detektiert werden.

Schließlich hat es sich als vorteilhaft gezeigt, wenn der Kühlpfad Teil eines Kühlkreislaufs ist, in welchen ein Wärmetauscher integriert ist. Ein derartiges System ist besonders betriebssicher und einfach zu betreiben.

Die vorstehend im Zusammenhang mit der erfindungsgemäßen Kühleinrichtung beschriebenen Vorteile ergeben sich in ebensolcher Weise für das Verfahren zum Betreiben dieser Kühleinrichtung gemäß Patentanspruch 6.

Das Verfahren zeichnet sich zudem insbesondere dadurch aus, dass auf einfache Weise jeweilige Temperaturdifferenzen der mittels der beiden Temperatursensoren ermittelten Temperaturen des Kühlmittels berechnet werden können und sich dann auf einfache Weise ein Ausfall des Massenstroms ermitteln lässt, wenn beispielsweise ein Grenzwert dieser Temperaturdifferenz überstiegen wird und der Gradient der Temperaturveränderung des Kühlmittels im Nahbereich der Verlustleistungsquelle der Temperaturveränderung an der demgegenüber weiter von der Verlustleistungsquelle entfernten Erfassungsstelle der Temperatur des Kühlmittels vorauseilt.

In diesem Zusammenhang hat es sich als besonders vorteilhaft gezeigt, wenn bei Überschreiten des Grenzwerts ein Signal über den Ausfall des Massenstroms des Kühlmittels an die übergeordnete Anlage übermittelt wird, damit das System abgeschaltet und die entsprechenden Komponenten der Anlage vor Überhitzung geschützt werden können.

Schließlich ergibt sich bei dem erfindungsgemäßen Verfahren der besonders günstige Vorteil, dass bei Ermittlung eines zeitlichen Temperaturgradienten, der an dem, dem Überdeckungsbereich abgewandten und Zulauf zugewandten, Temperatursensor zuerst erfasst wird, von einem Temperatursprung des Kühlmittels in Folge der sich verändernden Umgebungsbedingungen und insbesondere in Folge von damit einhergehenden Temperaturschwankungen ausgegangen werden kann. Da somit auf einfache Weise ein zeitlicher Temperaturgradient von dem, dem Überdeckungsbereich abgewandten und Zulauf zugewandten, Temperatursensor zuerst erfasst wird, kann somit ein Ausfall des Massenstroms in besonders einfacher Weise von einem derartigen Temperatursprung unterschieden werden, was erheblich zur Zuverlässigkeit der Anlage beiträgt, sodass unbeabsichtigte beziehungsweise unzutreffende Abschaltungen des Gesamtsystems besonders einfach und wirksam vermieden werden können.

Weitere Vorteile und Einzelheiten der Erfindung ergeben sich aus der nachfolgenden Beschreibung bevorzugter Ausführungsbeispiele sowie anhand der Zeichnungen. In den FIG bezeichnen dabei gleiche Bezugszeichen gleiche Merkmale und Funktionen.

Es zeigen:
- FIG 1: eine schematische Ansicht einer Kühleinrichtung für ein Umrichtersystem einer elektrischen Anlage eines Schienenfahrzeugs gemäß dem Stand der Technik;
- FIG 2: eine schematische Ansicht einer Kühleinrichtung für ein Umrichtersystem einer elektrischen Anlage eines Schienenfahrzeugs gemäß einer ersten Ausführungsform der Erfindung;
- FIG 3: eine schematische Ansicht der Kühleinrichtung gemäß FIG 2, anhand welcher die Funktionsweise beim Ausfall eines Massenstroms eines Kühlmittels der Kühleinrichtung angedeutet ist;
- FIG 4: ein Diagramm der über die Zeit erfassten Temperaturen einer Temperatursensorik, wobei anhand einer Temperaturdifferenz ein Ausfall des Massenstroms des Kühlmittels erfassbar ist;
- FIG 5: ein weiteres Diagramm des Verlaufs der mittels der entsprechenden Temperatursensoren ermittelten Temperaturen über der Zeit, wobei jeweilige Temperaturverläufe erkennbar sind, mittels welchen ein Temperatursprung des Kühlmittels in Folge geänderter Umgebungsbedingungen des Schienenfahrzeugs ermittelbar sind; und in
- FIG 6: eine schematische Ansicht einer Kühleinrichtung für ein Umrichtersystem einer elektrischen Anlage eines Schienenfahrzeugs gemäß einer weiteren Ausführungsform, bei welcher der Ausfall mehrerer Verlustleistungsquellen über eine Sensorik ermittelt werden kann.

Während in FIG 1 eine Kühleinrichtung für ein Umrichtersystem einer elektrischen Anlage eines Schienenfahrzeugs gemäß dem Stand der Technik gezeigt ist, soll nun im Weiteren anhand der FIG 2 bis 6 die erfindungsgemäße Kühleinrichtung für ein Umrichtersystem einer elektrischen Anlage eines Schienenfahrzeugs sowie eines Verfahrens zum Betreiben einer derartigen Kühleinrichtung anhand von zwei Ausführungsbeispielen beschrieben werden.

Hierbei zeigt FIG 2 eine schematische Ansicht einer Kühleinrichtung für ein Umrichtersystem einer elektrischen Anlage eines Schienenfahrzeugs mit einer Verlustleistungsquelle 30, welche beispielsweise als SiC-MOSFET-Modul (Metaloxide-Semiconductor-Field-Effect-Transistor = Metall-Oxid-Halbleiter-Feldeffekttransistor) ausgebildet ist. Eine derartige Komponente erzeugt ein hohes Maß an thermischer Energie beziehungsweise Wärme, welche entsprechend abgeführt werden muss, um gegen Überhitzung geschützt zu sein. Im vorliegenden Ausführungsbeispiel ist die Verlustleistungsquelle 30 hierzu mit einem entsprechend thermisch gut leitenden Kühlkörper 32 verbunden, wobei mit Pfeilen 34 ein Verlustleistungseintrag beziehungsweise ein Wärmeübergang der von der Verlustleistungsquelle 30 erzeugten thermischen Energie in den Kühlkörper 32 symbolisiert wird. Im vorliegenden Fall sind die Verlustleistungsquelle 30 und der Kühlkörper 32 separat ausgebildet. Gleichfalls ist es jedoch auch denkbar, dass die beiden Komponenten einstückig gestaltet sind. Ebenso kann die Verlustleistungsquelle 30 einen integrierten Kühlkörper 32 aufweisen.

Wie des Weiteren aus FIG 2 erkennbar ist, ist der Kühlkörper 32 von einem Kühlkanal 36 durchsetzt, welcher selbst Teil eines Kühlpfads 39 des Kühlkreislaufs 38 ist. In diesen, in FIG 2 symbolisch angedeuteten Kühlkreislauf 38 sind ein Wärmetauscher 40 und eine Pumpe 42 integriert, mittels welcher ein flüssiges oder gasförmiges Kühlmedium beziehungsweise Kühlmittel innerhalb des Kühlkreislaufs 38 umgewälzt wird beziehungsweise zirkuliert. Anstelle einer Pumpe 42 wäre natürlich auch eine andere Umwälzeinrichtung denkbar.

Über den Wärmetauscher 40 wird in dem Kühlmittel gespeicherte Wärme, welche diese durch den Verlusteintrag der Verlustleistungsquelle 30 aufgenommen hat, in an sich bekannter Weise an ein zweites Stoffstrom übertragen. Dieser zweite Stoffstrom wird bei Schienenfahrzeugen beispielsweise durch die Umgebungsluft gebildet, welche beispielsweise mittels eines Lüfters beschleunigt wird und dann den Wärmetauscher 40 beziehungsweise Kühler durchströmt und hierdurch den Stoffstrom beziehungsweise Massenstrom des in dem Kühlkreislauf 38 zirkulierenden Kühlmittels abkühlt.

Das in dem Wärmetauscher 40 abgekühlte Kühlmittel tritt innerhalb des Kühlpfads 39 im Bereich eines Eintritts 44 des Massenstroms in den innerhalb des Kühlkörpers 32 vorgesehen Kühlkanal 36 ein. Im weiteren Verlauf des Massenstroms beziehungsweise im weiteren Verlauf einer mit einem Pfeil 46 angegebenen Transportrichtung des Kühlkreislaufs 38 beziehungsweise des Kühlpfads 39 gelangt das Kühlmittel dann in einen Längenbereich beziehungsweise in eine Passage 48 des Massenstroms innerhalb des Kühlkanals 36 in den Überdeckungsbereich des Kühlkreislaufs 38 mit der Verlustleistungsquelle 30. Der Überdeckungsbereich von Verlustleistungsquelle 30 und Kühlkreislauf 38 beziehungsweise Kühlpassage 39 ist als derjenige Bereich definiert, in dem der hauptsächliche Wärmestrom von Wärmequelle zum Kühlmittel im Normalbetrieb geführt wird. Unter der Passage 48 ist demzufolge derjenige Abschnitt des Kühlkanals 36 zu verstehen, in welchem sich der Massenstrom des Kühlmittels im Wesentlichen in Überdeckung mit der Verlustleistungsquelle 30 befindet. Im Bereich dieser Passage 48 erfolgt demzufolge auch der Verlustleistungseintrag (Pfeile 34) aus der Verlustleistungsquelle 30 über den Kühlkörper 32 in das Kühlmittel. Im vorliegenden Fall wird als Kühlmittel beispielsweise Wasser verwendet. Nachdem das Kühlmittel den Kühlkörper 32 passiert hat, tritt es an einem Austritt 50 wieder aus diesem beziehungsweise aus dem Kühlkanal 36 aus und gelangt von dort aus wiederum zur Pumpe 42, mittels welcher das Kühlmittel im weiteren Verlauf wiederum zum Wärmetauscher 40 gelangt, in welchem es die von der Verlustleistungsquelle 30 aufgenommene Wärme an die den Wärmetauscher 40 durchströmende Umgebungsluft abgibt.

Weiterhin ist aus FIG 2 erkennbar, dass eine Temperatursensorik Teil der Kühleinrichtung ist, welche im vorliegenden Fall einen ersten Temperatursensor 52 und einen zweiten Temperatursensor 54 umfasst. Der eine, erste Temperatursensor 52 ist dabei - bezogen auf die Transportrichtung 46 des Kühlmittels - im Bereich des Eintritts 44 des Massenstroms in dem Kühlmittelkörper 32 angeordnet. Der zweite Temperatursensor 54 ist im Nahbereich beziehungsweise unmittelbar vor der Passage 48 des Massenstroms durch den Überdeckungsbereich des Kühlkreislaufs 38 beziehungsweise Kühlpfads 39 mit der Verlustleistungsquelle 30 angeordnet. Die Temperatursensoren 52, 54 sind demzufolge - bezogen auf die Transportrichtung 46 des Kühlmittels - vor der Passage 48 des Massenstroms durch den Überdeckungsbereich des Kühlkreislaufs 38 mit der Verlustleistungsquelle 30 positioniert. Dabei können die beiden Temperatursensoren 52, 54 gegebenenfalls auch außerhalb des Kühlkörpers 32 unmittelbar in entsprechenden Leitungen des Kühlkreislaufs 38 angeordnet sein. Die vorliegende Anordnung der Temperatursensoren 52, 54 innerhalb des Kühlkörpers 32 ist jedoch besonders vorteilhaft, da hier eine gute thermische Kopplung der Sensoren an das Kühlmedium vorliegt.

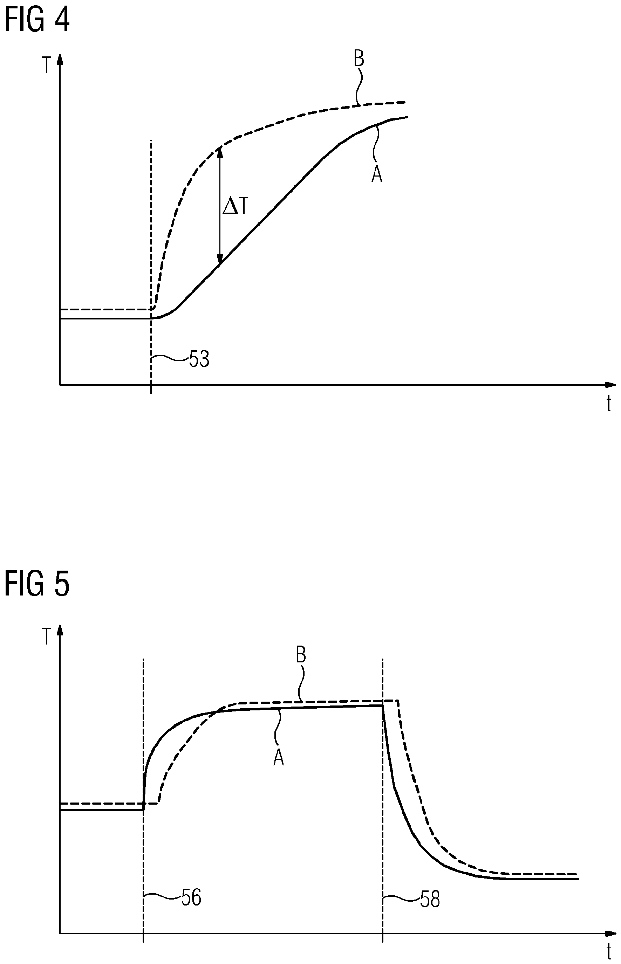

Das Verfahren zum Betreiben der Kühleinrichtung sieht nun vor, dass bei zirkulierendem Kühlmittel mittels der beiden Temperatursensoren 52, 54 die jeweilige Temperatur am Eintritt 44 beziehungsweise vor der Passage 48 ermittelt wird. Wie nun aus dem Diagramm gemäß FIG 4 nahe der dortigen Ordinate erkennbar ist, verlaufen entsprechende Temperaturmesskurven A, B über die Zeit üblicherweise konstant und parallel zueinander. Die Temperaturmesskurve A der mittels des Temperatursensors 52 am Eintritt 44 ermittelten Temperatur ist dabei üblicherweise geringer als die Temperaturmesskurve B der im Bereich vor der Passage 48 mittels des Temperatursensors 54 ermittelten Temperatur. Dies hängt damit zusammen, dass an der Messstelle des zweiten Temperatursensors 54 der Verlustleistungseintrag durch die Verlustleistungsquelle 30 dazu führt, dass in diesem Bereich der Kühlkörper 32 beziehungsweise das in diesen Bereich strömende Kühlmedium eine leicht erhöhte Temperatur hat. Die Temperatur A entspricht demzufolge der Kühlmittelzulauftemperatur. Die vom Temperatursensor 54 hingegen gemessene Temperatur B ist nur geringfügig höher als die Temperatur A, da sich ein Teil der von der Verlustleistungsquelle 30 eingetragenen Leistung entgegen der Strömungsrichtung des Kühlmittels ausbreitet und so die Temperatur, welche durch die Temperaturmesskurve B repräsentiert wird, geringfügig erhöht. Eine Temperaturdifferenz kann somit ermittelt werden, indem der Wert der Temperaturmesskurve B um den Wert der Temperaturmesskurve A subtrahiert wird. Im normalen Betrieb der Kühleinrichtung wird somit eine geringe positive Temperaturdifferenz ΔT ermittelt.

Kommt es nun zu einem Zeitpunkt (Linie 53) zu einem Ausfall der Pumpe 42 oder einem sonstigen Erliegen des Massenstroms des Kühlmittels innerhalb des Kühlkreislaufs 38, so resultiert in Folge der weiterhin aus der Verlustleistungsquelle 30 in den Kühlkörper 32 beziehungsweise in das Kühlmittel eingebrachten Verlustleistung eine Temperaturerhöhung direkt unter der Verlustleistungsquelle 30 beziehungsweise über die Passage 48 im Überdeckungsbereich der Verlustleistungsquelle 30 mit dem Kühlkanal 36. Durch die resultierende Temperaturdifferenz beziehungsweise durch Ausbreitung der in das Kühlmedium eingetragenen thermischen Energie beziehungsweise Wärme ergibt sich ein Wärmestrom entgegen der normalen Flussrichtung 46 des Massenstroms des Kühlmittels, wie dies in FIG 3 anhand entsprechender Linien 55 angedeutet ist.

Aufgrund dieses Wärmestroms entgegen der normalen Flussrichtung 46 erhöht sich die durch den Temperatursensor 54 ermittelte Temperatur sehr schnell und stark, wie in FIG 4 anhand der Temperaturkurve B erkennbar ist. Deutlich verzögert und in geringerem Umfang aufgrund des Abstandes zur Verlustleistungsquelle 30 erhöht sich auch die mittels des Temperatursensors 52 gemessene Temperatur am Eintritt 44 in den Kühlkörper 32. Diese Verzögerung ergibt sich in Folge des sich entgegen der normalen Flussrichtung 46 ausbreitenden Wärmestroms, welcher nach Erreichen der Messstelle im Bereich des Temperatursensors 54 noch einige Zeit benötigt, bis auch der Temperatursensor 52 im Bereich des Eintritts 44 in den Kühlkörper 32 eine entsprechende Temperaturerhöhung misst. Den Verlauf dieser Temperaturkurve A im Bereich des Eintritts 44 ist in FIG 4 ebenfalls erkennbar.

Aus FIG 4 wird somit deutlich, dass nach dem mit der gestrichelten Linie 53 angedeuteten Zeitpunkt des Ausfalls der Kühlmittelumwälzung beziehungsweise der Zirkulation des Massenstroms innerhalb des Kühlkreislaufs 38 eine deutliche Erhöhung der Temperaturmesskurve B und - nachfolgend und moderater - auch der Temperaturmesskurve A erfolgt. Somit steigt die Temperaturdifferenz ΔT an, wie dies deutlich aus dem Diagramm gemäß FIG 4 erkennbar ist.

Die Temperaturdifferenz ΔT kann dabei mittels einer Auswerteinheit kontinuierlich geprüft werden. Die Temperaturdifferenz ΔT kann in einer Recheneinheit mit einem Grenzwert verglichen werden, welcher einen Ausfall des Massenstroms definiert. Bei Überschreiten des Grenzwerts kann ein Signal über den Ausfall des Massenstroms des Kühlmittels an die Anlage übermittelt werden. Ein Ausfall des Kühlmittelmassenstroms liegt demzufolge immer dann vor, wenn die Temperaturdifferenz ΔT zwischen dem Temperatursensor 54 und dem Temperatursensor 52 deutlich höher ist als im Normalbetrieb und der Temperaturanstieg im Bereich des Temperatursensors 54 dem Temperaturanstieg im Bereich des Temperatursensors 52 vorauseilt. Beide Teile dieser Bedingung können mit einer geeigneten, überlagerten Steuerung geprüft werden.

FIG 5 zeigt ein weiteres Diagramm der Temperatur der beiden Temperaturmesskurven A, B über die Zeit t. Hierbei sind im Diagramm zwei Temperatursprünge 56, 58 zu jeweiligen Zeitpunkten eingetragen. Derartige Temperatursprünge 56, 58 entstehen beispielsweise bei einer signifikanten Änderung der Bedingungen im Wärmetauscher 40, nämlich beispielsweise dann, wenn das Schienenfahrzeug in einen Tunnel einfährt, in welchem eine deutlich andere Temperatur vorherrscht als zuvor. Ist demzufolge die Kühlmittelumwälzung und die Zirkulation des Massenstroms aktiv, und es kommt zu einem Temperatursprung beispielsweise im Stoffstrom des Wärmetauschers, also der Kühlluft, so führt dies entsprechend zu einem Temperatursprung des Kühlmittels. Dieser Sprung entsteht im Kühlmittelzulauf, und zwar aufgrund der Flussrichtung des Kühlmittels immer zunächst am Temperatursensor 52 nahe des Eintritts 44 und mit zeitlichem Verzug danach vor Eintritt des Kühlmittels in die Passage 48 am Temperatursensor 54. Damit ist die Detektionsreihenfolge der Temperaturänderung genau umgekehrt wie beim Ausfall des Massenstroms, wie dieser zuvor beschrieben worden ist. Somit wird beim ersten Temperatursprung an der Linie 56 eine negative Temperaturdifferenz ΔT zwischen der Temperaturmesskurve B und der Temperaturmesskurve A ermittelt, welche sich in Folge des geänderten Vorzeichens von derjenigen Temperaturdifferenz ΔT unterscheidet, welche bei einem Ausfall des Massenstroms detektiert wird. Somit kann ein Kühlmittelsprung im Zulauf klar von einem Massenstromausfall des Kühlmittels unterschieden werden.

Der im Bereich der Linie 58 angedeutete zweite Temperatursprung des Kühlmittels entsteht beispielsweise nach Verlassen des Tunnels bis sich der Verlauf der Temperaturmesskurven A und B über die Zeit wieder normalisiert hat.

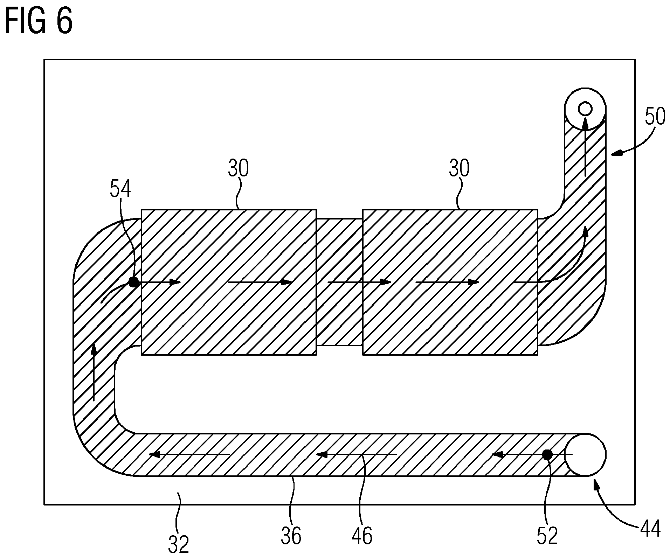

FIG 6 zeigt schließlich ein weiteres Ausführungsbeispiel der Kühleinrichtung in einer schematischen Ansicht, wobei der Kühlkanal 36 des Kühlkreislaufs 38 äußerst schematisch angedeutet ist. An diesem Kühlkanal 36 ist ein Kühlkörper 32 in Form einer Kühlplatte angeordnet, auf welchem wiederum zwei Verlustleistungsquellen 30 beispielsweise in Form jeweiliger Leistungshalbleiter angeordnet sind. Wiederum erkennbar sind die jeweiligen Temperatursensoren 52, 54, welche entsprechend in einem größeren beziehungsweise kleineren Abstand zur jeweiligen Verlustleistungsquelle 30 angeordnet sind. Dabei ist insbesondere erkennbar, dass auch beim Einsatz von zwei Verlustleistungsquellen 30 lediglich eine Temperatursensorik mit einem Paar von Temperatursensoren 52, 54 erforderlich ist, mittels welchen dann sowohl der Ausfall der in Transportrichtung 46 des Kühlmediums betrachtet vorderen als auch hinteren Verlustleistungsquelle 30 detektiert werden kann. Mit anderen Worten ist auch beim Einsatz von zwei Verlustleistungsquellen 30 somit lediglich ein Paar von Temperatursensoren 52, 54 erforderlich.

## Patentansprüche

1. Kühleinrichtung für eine elektrische Anlage, insbesondere für ein Umrichtersystem einer elektrischen Anlage eines Schienenfahrzeugs, mit einem Kühlpfad (39), in welchem wenigstens eine Verlustleistungsquelle (14) angeordnet ist und welcher von einem Kühlmittel durchströmbar ist, und mit einer Temperatursensorik zum Erfassen eines Ausfalls eines Massenstroms des Kühlmittels, welche wenigstens zwei in Transportrichtung (46) des Kühlmittels voneinander beabstandet in den Kühlpfad (39) integrierte Temperatursensoren (52,54) umfasst, **dadurch gekennzeichnet , dass** die beiden Temperatursensoren (52,54) in Transportrichtung (46) des Kühlmittels vor einer Passage (24) des Massenstroms des Kühlmittels durch einen Überdeckungsbereich des Kühlpfads (39) mit der Verlustleistungsquelle (14) angeordnet sind.

2. Kühleinrichtung nach Anspruch 1, **dadurch gekennzeichnet, dass** die Verlustleistungsquelle (14) mit einem in den Kühlpfad (39) integrierten Kühlkörper (12) Wärme leitend gekoppelt ist, an welchem die beiden Temperatursensoren (52,54) angeordnet sind.

3. Kühleinrichtung nach Anspruch 2, **dadurch gekennzeichnet, dass** der eine Temperatursensor (52) in Transportrichtung (46) des Kühlmittels im Bereich eines Eintritts (44) des Massenstromes in den Kühlkörper (12) und der weitere Temperatursensor (54) im Nahbereich vor der Passage (24) des Massenstroms durch den Überdeckungsbereich des Kühlkreislaufes (38) mit der Verlustleistungsquelle (14) angeordnet ist.

4. Kühleinrichtung nach Anspruch 2 oder 3, **dadurch gekennzeichnet , dass** eine Mehrzahl von Verlustleistungsquellen (14,30) vorgesehen ist, wobei die beiden Temperatursensoren (52,54) voneinander beabstandet in Transportrichtung des Kühlmittels vor einer Passage (24,48) des Massenstroms durch einen Überdeckungsbereich des Kühlpfads (39) mit einer der Verlustleistungsquellen (14) angeordnet sind.

5. Kühleinrichtung nach einem der vorhergehenden Ansprüche, **dadurch gekennzeichnet, dass** der Kühlpfad (39) Teil eines Kühlkreislaufs (38) ist, in welchem ein Wärmetauscher (40) integriert ist.

6. Verfahren zum Betreiben einer Kühleinrichtung für eine elektrische Anlage, insbesondere für ein Umrichtersystem einer elektrischen Anlage eines Schienenfahrzeugs, bei welchem ein Kühlpfad (39), in welchem wenigstens eine Verlustleistungsquelle (14,30) angeordnet ist, von einem Kühlmittel durchströmt wird, und bei welchem ein Ausfall eines Massenstromes des Kühlmittels mit einer Temperatursensorik erfasst wird, welche wenigstens zwei in Transportrichtung (56) des Kühlmittels voneinander beabstandet in den Kühlpfad (39) integrierte Temperatursensoren (52,54) umfasst, **dadurch gekennzeichnet , dass** mittels der beiden Temperatursensoren (52,54), welche in Transportrichtung (46) des Kühlmittels vor einer Passage (24,48) des Massenstroms durch einen Überdeckungsbereich des Kühlpfads (39) mit der Verlustleistungsquelle (14,30) angeordnet sind, eine jeweilige Temperatur des Kühlmittels erfasst und anhand dieser ermittelten Temperaturen des Kühlmittels ein Ausfall des Massenstroms überwacht wird.

7. Verfahren nach Anspruch 6, **dadurch gekennzeichnet, dass** die jeweilige Temperatur des Kühlmittels mittels der beiden Temperatursensoren (52,54) an einem in den Kühlpfad (39) integrierten Kühlkörper (12,32) ermittelt wird, welcher Wärme leitend mit der Verlustleistungsquelle (14,30) gekoppelt ist.

8. Verfahren nach Anspruch 7, **dadurch gekennzeichnet, dass** die Temperatur des Kühlmittels in dessen Transportrichtung (56) einerseits im Bereich eines Eintritts (44) des Massenstromes in den Kühlkörper (12,32) und andererseits im Nahbereich vor der Passage (24,48) des Massenstroms durch den Überdeckungsbereich des Kühlpfads (39) mit der Verlustleistungsquelle (14, 30) erfasst wird.

9. Verfahren nach einem der Ansprüche 6 bis 8, **dadurch gekennzeichnet , dass** mittels einer Recheneinrichtung eine Temperaturdifferenz (ΔT) der beiden erfassten Temperaturen des Kühlmittels ermittelt und mit einem Grenzwert verglichen wird und dass mittels der Recheneinrichtung die Erfassungsreihenfolge einer Temperaturänderung des Kühlmittels an den Messstellen ermittelt und mit einem Grenzwert verglichen wird.

10. Verfahren nach Anspruch 9, **dadurch gekennzeichnet, dass** bei Überschreiten des Grenzwerts ein Signal über den Ausfall des Massenstroms des Kühlmittels an die elektrische Anlage übermittelt wird.

11. Verfahren nach Anspruch 9 oder 10, **dadurch gekennzeichnet , dass** durch Auswerten der Temperaturdifferenz und der Erfassungsreihenfolge einer Temperaturänderung des Kühlmittels an den beiden Sensoren ein Temperatursprung des Kühlmittels von einem Ausfall des Massenstromes des Kühlmittels unterschieden wird.
